# FASCICULE DE BREVET EUROPEEN

(11) **EP 2 684 228 B1**
(45) Date de publication et mention de la délivrance du brevet: **18.01.2017**
(21) Numéro de dépôt: 12707337.7
(22) Date de dépôt: 07.03.2012
(51) Int. Cl.: H01L 45/00, G11C 13/00, H01L 27/105

(54) **DISPOSITIF ÉLECTRONIQUE DE TYPE MÉMOIRE**
ELEKTRONISCHE SPEICHERVORRICHTUNG
ELECTRONIC MEMORY DEVICE

(30) Priorité: 09.03.2011 FR 1151913
(43) Date de publication de la demande: 15.01.2014
(73) Titulaire: Commissariat à l'Énergie Atomique et aux Énergies Alternatives, 75015 Paris (FR)
(72) Inventeur: SINGH, Pawan, F-38000 Grenoble (FR)
(74) Mandataire: Lebkiri, Alexandre
(86) Numéro de dépôt international: PCT/EP2012/053931
(87) Numéro de publication internationale: WO 2012/136435

(56) Documents cités:
- WO-A2-2004/100217
- JP-A- 2010 153 591
- US-B1- 7 560 721

## Description

La présente invention concerne un dispositif électronique ; l'invention concerne plus particulièrement le domaine des mémoires réinscriptibles, et plus spécifiquement celui des mémoires réinscriptibles non volatiles à conduction ionique (mémoires CBRAM ou « Conductive Bridging RAM »).

En fonction des applications et des performances visées, différents types de mémoires sont utilisées.

Ainsi, les mémoires de type SRAM, ou mémoires vives statiques, offrent des temps d'écriture ultra-rapides, requis par exemple lors de calculs par un micro-processeur. L'inconvénient majeur de ces mémoires est qu'elles sont volatiles et que la taille du point mémoire relativement grande ne permet pas d'obtenir une grande capacité de stockage dans un volume raisonnable.

Les mémoires de type DRAM, ou mémoires vives dynamiques, réalisant le stockage de charges électriques dans des capacités, offrent une grande capacité de stockage. Ces mémoires possèdent toutefois des temps d'écriture plus élevés (quelques dizaines de nanosecondes) que ceux des mémoires de type SRAM et sont elles-aussi volatiles, le temps de rétention de l'information étant de l'ordre de quelques dizaines de millisecondes.

Pour des applications qui nécessitent un stockage de l'information même lorsque la tension est coupée, des mémoires non volatiles de type EEPROM ou FLASH qui réalisent un stockage de charges sur des grilles flottantes de transistors à effet de champ, sont utilisées. Ces mémoires présentent toutefois des inconvénients :
- temps d'écriture longs (quelques microsecondes),
- densité limitée car la réduction de la taille des transistors conduit à une diminution du signal de lecture, c'est-à-dire une baisse de la différence entre les deux états du point mémoire, et une réduction de la durée de rétention de l'information,
- nombre de cycles d'écriture limité car la capacité de rétention de l'information diminue au fur et à mesure des cycles d'écriture à cause de la création de défauts dans l'oxyde de grille des transistors, permettant aux électrons de s'échapper de la grille flottante.

Plus récemment, d'autres types de mémoires non volatiles réinscriptibles sont apparus, basés sur des matériaux actifs tels que des matériaux à conduction ionique (mémoires CBRAM ou « Conductive Bridging RAM »). Ces mémoires sont des mémoires de type résistive (i.e. elles peuvent présenter au moins deux états « off » ou « on » correspondant au passage d'un état résistif (état « OFF ») à un état moins résistif (état « ON »)).

Le fonctionnement des dispositifs de type CBRAM est basé sur la formation, au sein d'un électrolyte solide, d'éléments métalliques appelés « dendrites » entre deux électrodes, lorsque ces électrodes sont portées à des potentiels respectifs appropriés. La formation des dendrites permet d'obtenir une conduction électrique donnée entre les deux électrodes. En modifiant les potentiels respectifs appliqués aux électrodes, il est possible de modifier la répartition et le nombre des dendrites, et de modifier ainsi la conduction électrique entre les deux électrodes. En inversant par exemple le potentiel entre les électrodes, il est possible de faire disparaître ou de réduire les dendrites, de manière à supprimer ou à réduire considérablement la conduction électrique due à la présence des dendrites. Les dispositifs CBRAM peuvent ainsi avoir un fonctionnement à deux états : un état dit « ON » et un état dit « OFF » et jouer par exemple le rôle de cellules mémoires.

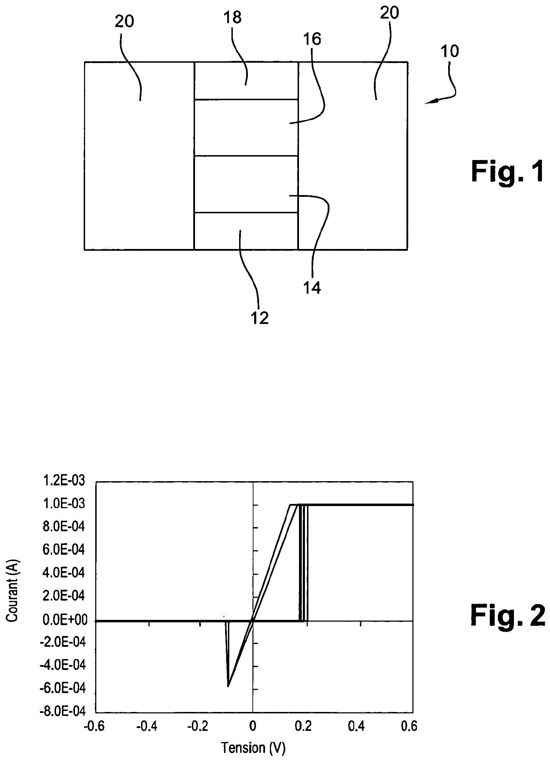

La figure 1 représente un schéma de principe d'un dispositif électronique 10 de type CBRAM. Ce dispositif 10 comporte un électrolyte solide 14, par exemple à base de chalcogénure dopé tel que du GeSe, disposé entre une électrode inférieure 12 de nickel, formant une cathode inerte, et une portion de métal ionisable 16 à base d'argent, c'est-à-dire une portion de métal pouvant facilement former des ions métalliques (ici des ions argent Ag⁺), et formant une anode. Une électrode supérieure 18 est disposée sur la portion de métal ionisable 16. Ces éléments sont isolés électriquement par des portions diélectriques latérales 20 à base de SiO₂ ou de SiN, disposées autour de ces éléments. Le dispositif 10 représenté sur la figure 1 forme typiquement un point mémoire, c'est-à-dire une cellule mémoire unitaire, d'une mémoire comportant une multitude de ces dispositifs mémoires.

L'état mémoire d'un dispositif mémoire CBRAM résulte de la différence de résistivité électrique entre deux états : ON et OFF. A l'état OFF, les ions métalliques (ici des ions Ag+) issus de la portion de métal ionisable 16 sont dispersés dans tout l'électrolyte solide 14. Ainsi, aucun contact électrique n'est établi entre l'anode et la cathode, c'est-à-dire entre la portion de métal ionisable 16 et l'électrode inférieure 12. L'électrolyte solide 14 forme une zone électriquement isolante de grande résistivité entre l'anode 16 et la cathode 12. Une opération d'écriture dans le dispositif mémoire 10 est réalisée en appliquant une différence de potentiel entre l'anode 16 et la cathode 12, par exemple sous la forme d'une rampe de tension. Les ions métalliques Ag+ initialement dispersés dans l'électrolyte solide 14 migrent alors vers la cathode 12 pour former un dépôt métallique. Ce dépôt métallique prend la forme de nanofils métalliques, appelés « dendrites », croissant progressivement au sein du milieu électrolytique sous l'effet de la tension appliquée et finissant par établir des ponts de conduction électrique entre l'anode 16 et la cathode 12 : c'est l'état ON. L'électrolyte solide 14 forme alors une zone électriquement conductrice grâce aux nanofils métalliques formés entre l'anode 16 et la cathode 12. Une opération d'effacement est réalisée en appliquant une différence de potentiel de signe opposé, entre les électrodes 12 et 18, le dépôt métallique (les nanofils) précédemment formé se « dissolvant » sous forme ionique dans l'électrolyte solide 14, permettant au dispositif mémoire 10 de revenir à l'état OFF. On notera que la première opération réalisée sur un dispositif CBRAM consiste à former la ou les dendrites conducteurs entre l'anode et l'électrode, le passage de l'état ON à l'état OFF se faisant ensuite en réduisant la longueur de la ou des dendrites sans pour autant dissoudre la totalité des dendrites : cette réduction de longueur suffit en effet à passer d'un état conducteur (i.e. la dendrite assure la contact entre les électrodes) à un état non conducteur (i.e. la dendrite n'est plus assez longue pour assurer la conduction).

Un tel dispositif CBRAM présente toutefois certains inconvénients.

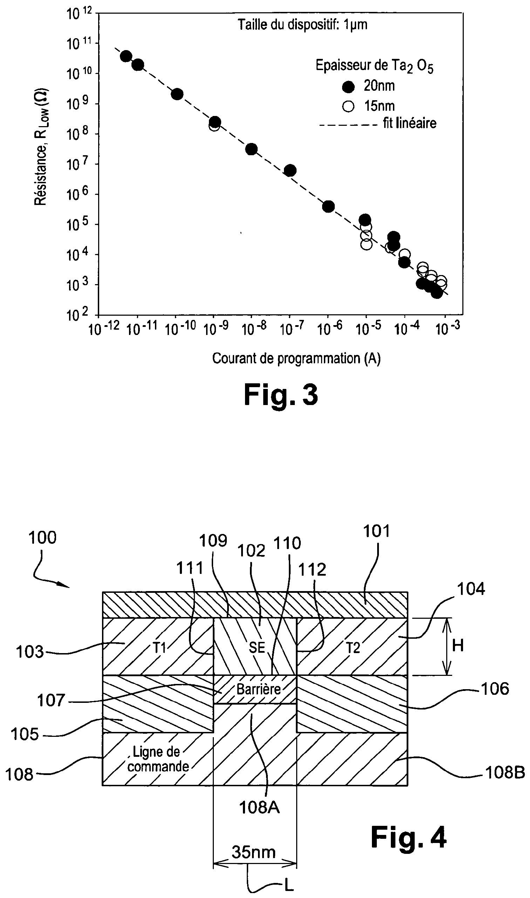

Ainsi, la formation du pont conducteur (dendrite) se fait par une réaction d'oxydo-réduction avec des ions Ag+ qui migrent de l'anode vers la cathode et des électrons qui vont dans le sens inverse. Cette réaction impose de créer une différence de potentiel entre les deux électrodes et donc d'injecter un courant qui va traverser l'électrolyte. La figure 2 illustre l'évolution du courant traversant l'électrolyte d'un dispositif CBRAM en fonction de la tension aux bornes des électrodes. Il convient tout d'abord de noter que le courant d'électrons (i.e. le courant électrochimique) nécessaire à la réaction d'oxydo-réduction est largement minoritaire dans le courant d'électrons total traversant l'électrolyte, la majorité du courant formant un courant de fuite parasite. Dans le cas présent, on constate que l'intensité du courant traversant l'électrolyte nécessaire pour faire passer le dispositif CBRAM d'un état OFF à un état ON est environ égale à 10⁻³ A. Un tel courant correspond à la différence de potentiel nécessaire (i.e. ici 0,2 V) pour passer d'une résistance R_{OFF} de l'ordre de 10⁹ Ohms à une résistance R_{ON} de l'ordre de 10² Ohms. Comme illustré sur la figure 3, la résistance R_{ON} à l'état passant est donc directement dépendante de l'intensité du courant traversant l'électrolyte. Ainsi, comme mentionné plus, pour un courant de l'ordre 10⁻³ A, on obtient une résistance de l'ordre de R_{ON} de l'ordre de 10² Ohms; en revanche, pour un courant de l'ordre 10⁻⁷ A, on obtient une résistance R_{ON} de l'ordre de 10⁷ Ohms : on a alors un ratio R_{OFF} sur R_{ON} de l'ordre de 10² ce qui peut s'avérer insuffisant pour certaines applications. On est ainsi confronté à deux contraintes dont les effets s'opposent : d'une part, il convient d'obtenir un ratio suffisamment important entre la résistance R_{OFF} et la résistance R_{ON} et d'autre part, il faut limiter le courant de fuite traversant l'électrolyte et entraînant une puissance consommée importante et un échauffement par effet Joule. En d'autres termes, réduire le courant de fuite entraîne l'obtention d'un ratio R_{OFF}/R_{ON} insuffisant et augmenter le courant de fuite permet d'obtenir un ratio suffisant mais génère un échauffement plus important du dispositif.

On notera par ailleurs que l'intensité du courant nécessaire pour faire passer le dispositif de l'état passant ON à l'état bloqué OFF est certes moins élevé que l'intensité nécessaire pour passer de l'état OFF à l'état ON mais génère également un échauffement du dispositif.

Des dispositifs de l'art antérieur sont décrits par WO 2004 / 100217 A2, JP 2010-153591 A ou US 7 560 721 B1.

Dans ce contexte, la présente invention vise à fournir un dispositif électronique de type mémoire à conduction ionique CBRAM permettant d'obtenir un rapport suffisamment élevé entre la résistance à l'état bloqué R_{OFF} et la résistance à l'état passant R_{ON} tout en limitant l'échauffement lié à la présence d'un courant de fuite parasite.

A cette fin, l'invention propose un dispositif selon la revendication 1.

On entend par dendrite au moins un nanofil métallique formé par la croissance d'ions métalliques au sein de l'électrolyte. La dendrite est créée une première fois sur toute la longueur de l'électrolyte (i.e. entre la première électrode et la deuxième électrode) par exemple par application d'une différence de potentiel entre la première et la deuxième électrode.

Grâce à l'invention, on utilise une troisième électrode qui va permettre de jouer sur la longueur de la dendrite initialement formée en cassant le pont conducteur formé par la dendrite entre la première et la deuxième électrode pour passer de l'état ON à l'état OFF (par exemple pour écrire un « 0 » dans le dispositif mémoire) ou en reformant ce pont conducteur entre la première et la deuxième électrode pour passer de l'état OFF à l'état ON (par exemple pour écrire un « 1 » dans le dispositif mémoire. Cette troisième électrode sert donc typiquement à écrire/effacer une information binaire dans le dispositif représentée par l'état résistif du dispositif.

Pour ce faire, la troisième électrode du dispositif selon l'invention est isolée de l'électrolyte par une barrière ionique et électronique. En appliquant un potentiel ad hoc sur la troisième électrode, on crée un champ électrique au sein de l'électrolyte dans la direction et l'intensité vont permettre soit de casser la (ou les) dendrite(s) présente(s) dans l'électrolyte en éloignant une partie des ions de la dendrite soit de reformer la dendrite en faisant revenir les ions pour former le pont conducteur. La troisième électrode étant totalement isolée ioniquement de l'électrolyte, il n'y aucun risque qu'une partie des ions métalliques issus de la dendrite pénètrent dans la barrière isolante pour venir se déposer sur la troisième électrode ou que certains ions métalliques présents dans l'électrolyte proviennent d'une réaction d'oxydo-réduction au niveau de la troisième électrode. En outre, la troisième électrode étant totalement isolée électroniquement de l'électrolyte, il est possible d'appliquer une tension élevée sur cette électrode de manière à obtenir un champ électrique suffisant pour obtenir un rapport R_{OFF} sur R_{ON} important avec un courant de fuite traversant l'électrolyte extrêmement réduit, voire nul. Dès lors, les pertes par effet Joule sont réduites. On notera que les phases d'écriture/effacement sont réalisées au moyen de la troisième électrode, la lecture de l'information liée à l'état résistif étant réalisée à l'aide d'un courant traversant l'électrolyte au moyen d'une différence de potentiel entre les première et deuxième électrodes.

Le dispositif selon l'invention peut également présenter une ou plusieurs des caractéristiques ci-dessous, considérées individuellement ou selon toutes les combinaisons techniquement possibles :
- ladite au moins une dendrite présente au moins une dimension non uniforme le long de l'électrolyte ;
- ledit contact entre ladite troisième électrode et ladite couche d'interface se fait uniquement sur une partie de la longueur totale de l'électrolyte de sorte que le champ électrique généré par l'application d'un potentiel sur ladite troisième électrode est concentré au niveau de ladite partie de la longueur totale de l'électrolyte ; on entend par longueur totale de l'électrolyte la longueur de l'électrolyte mesurée entre la première et la deuxième électrode (i.e. le long de la dendrite) ;
- ledit contact entre ladite troisième électrode et ladite couche d'interface se fait sur une zone sensiblement au milieu dudit électrolyte ;
- ledit contact entre ladite troisième électrode et ladite couche d'interface se fait sur une zone sensiblement agencée à une extrémité dudit électrolyte ;
- ledit contact entre ladite troisième électrode et ladite couche d'interface se fait sur une zone sensiblement agencée sur une moitié de la longueur dudit électrolyte ;
- ladite couche d'interface est réalisée dans un matériau diélectrique tel que du SiN, SiC, AIN ou SiCN ;
- ledit électrolyte solide est réalisé à partir d'un matériau chalcogénure tel qu'un séléniure ou un tellurure, de certains oxydes tels que SiO₂, HfO₂, Ta₂O₅, TiO₂, GdOx, CuOx, WOx, ou de sulfures tels que GeSₓ, CuₓS ou AgS ;
- le dispositif selon l'invention comporte deux zones isolantes électriquement aptes à isoler ladite troisième électrode respectivement desdites première et deuxième électrode ;
- ladite au moins une dendrite métallique est localisée à proximité de ladite couche d'interface ;
- le dispositif selon l'invention comporte une pluralité de dendrites métalliques.

La présente invention a également pour objet une cellule mémoire comportant un dispositif selon l'invention caractérisée en ce que les deux états binaires de la mémoire sont respectivement représentés par l'état résistif haut et bas du dispositif.

La présente invention a également pour objet un module d'interconnexion des blocs logiques appartenant à un circuit logique programmable comportant au moins un dispositif selon l'invention, ledit dispositif reliant deux zones de segments conducteurs.

D'autres caractéristiques et avantages de l'invention ressortiront clairement de la description qui en est donnée ci-dessous, à titre indicatif et nullement limitatif, en référence aux figures annexées, parmi lesquelles :
- la figure 1 représente schématiquement un dispositif à conduction ionique du type CBRAM selon l'état de la technique;
- la figure 2 illustre l'évolution de la tension aux bornes des électrodes du dispositif de la figure 1 en fonction du courant traversant l'électrolyte;
- la figure 3 représente l'évolution de la résistance RON à l'état passant du dispositif de la figure 1 en fonction du courant traversant l'électrolyte;
- la figure 4 illustre de manière schématique une vue en coupe latérale d'un dispositif électronique selon un premier mode de réalisation de l'invention ;
- les figures 5 à 7 illustrent le fonctionnement du dispositif de la figure 4 ;
- la figure 8 illustre de manière schématique une vue en coupe latérale d'un dispositif électronique selon un second mode de réalisation de l'invention ;
- la figure 9 illustre de manière schématique une vue en coupe latérale d'un dispositif électronique selon un troisième mode de réalisation de l'invention ;
- la figure 10 illustre de manière schématique une vue en coupe latérale d'un dispositif électronique selon un quatrième mode de réalisation de l'invention ;
- la figure 11 illustre de manière schématique une vue en coupe latérale d'un dispositif électronique selon un cinquième mode de réalisation de l'invention ;
- les figures 12a et 12b à 16a et 16b illustrent les étapes principales d'un exemple de procédé de fabrication d'un dispositif selon l'invention ;
- la figure 17 représenté une matrice d'interconnexion d'un circuit de type FPGA utilisant un dispositif selon l'invention.

Dans toutes les figures, les éléments communs portent les mêmes numéros de référence.

Les figures 1 à 3 ont déjà été décrites en référence à l'état de la technique.

La figure 4 représente schématiquement une vue en coupe latérale d'un dispositif électronique 100 de type mémoire à conduction ionique CBRAM (Conductive Bridging RAM) selon un premier mode de réalisation de l'invention.

Le dispositif électronique 100 comporte :
- une première zone isolante électriquement 101 ;
- un électrolyte solide 102 ;
- une première électrode 103 ;
- une deuxième électrode 104 ;
- une deuxième et une troisième zone isolantes électriquement 105 et 106 ;
- une quatrième zone isolante électriquement 107 dite «barrière de diffusion » ;
- une troisième électrode 108.

L'électrolyte solide 102 présente au moins trois faces de contact : ici, l'électrolyte 107 a la forme d'un parallélépipède rectangle avec quatre faces de contact :
- une face supérieure 109 ;
- une face inférieure 110 ;
- deux faces latérales 111 et 112.

L'électrolyte solide 102 peut être réalisé à partir d'un matériau chalcogénure tel qu'un séléniure (GeSe) ou un tellurure, de certains oxydes tels que SiO₂, HfO₂, Ta₂O₅, TiO₂, GdOx, CuOx, WOx, ou de sulfures tels que GeSₓ, CuₓS ou AgS.

Les première, deuxième et troisième zones isolantes électriquement 101, 105 et 106 sont par exemple réalisées dans un matériau diélectrique tel que du SiO₂.

La barrière de diffusion 107 est par exemple réalisée dans un matériau diélectrique tel que du SiN, SiC, AIN ou SiCN.

La première et la deuxième électrodes 103 et 104 sont par exemple deux électrodes métalliques en Cu ou en Ag.

La troisième électrode 108 est par exemple réalisée dans un matériau TiN revêtant une zone de Cu.

La première face latérale 111 de l'électrolyte 102 est en contact direct avec la première électrode 103.

La deuxième face latérale 112 de l'électrolyte 102 est en contact direct avec la deuxième électrode 104.

En d'autres termes, les première et deuxième électrodes 103 et 104 sont chacune en contact avec l'une des faces de l'électrolyte 102 de part et d'autre de ce dernier.

La première zone isolante électriquement 101 recouvre les faces supérieures de la première électrode 103, l'électrolyte 102 (face supérieure 109) et la deuxième électrode disposés successivement.

La face inférieure 110 de l'électrolyte 102 est en contact avec la barrière de diffusion 107.

La barrière de diffusion 107 agit comme une interface disposée entre la face inférieure 110 de l'électrolyte 102 et la troisième électrode 108 de sorte qu'elle empêche la diffusion d'ions Cu²⁺ entre l'électrolyte 102 et la troisième électrode 108; la barrière 107 est également isolante électriquement de sorte qu'elle empêche la conduction d'électrons entre l'électrolyte 102 et la troisième électrode 108.

La troisième électrode 108 présente une partie supérieure 108A et une partie inférieure 108B de longueur supérieure à la longueur de la partie supérieure 108A. Selon le monde de réalisation décrit ici, la longueur de la partie supérieure 108A est sensiblement égale à la longueur L de la barrière 107 de sorte que la zone supérieure 108A de la troisième électrode 108 est en contact avec la barrière 107 sur toute sa longueur L ; la longueur L est typiquement comprise entre 10 et 50 nm. La hauteur H de l'électrolyte 102 est typiquement comprise entre 10 et 100 nm.

Les deuxième et troisième zones isolantes électriquement 105 et 106 sont localisées entre la troisième électrode 108 et respectivement les première et deuxième électrodes 103 et 104 de manière à isoler électriquement la troisième électrode 108 des première et deuxième électrodes 103 et 104.

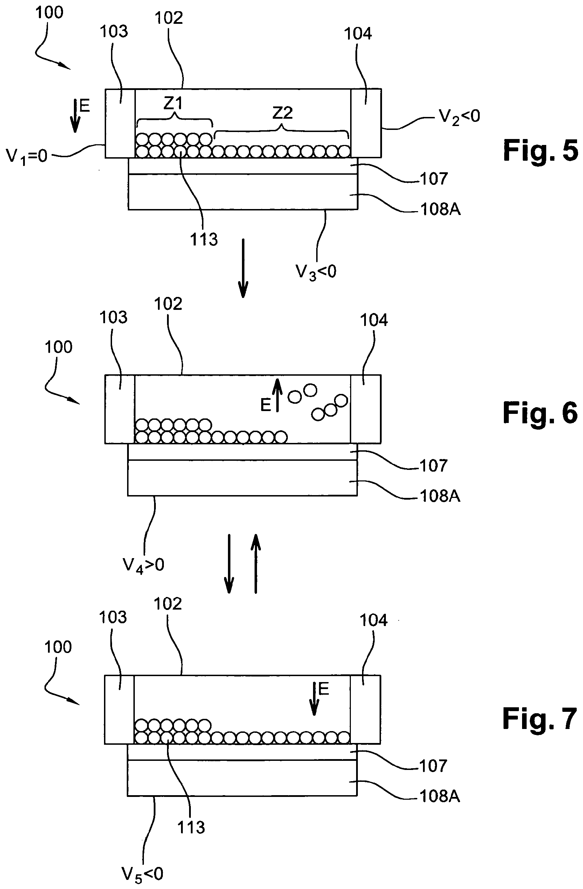

Le fonctionnement du dispositif 100 va maintenant être décrit en référence aux figures 5 à 7 qui illustrent respectivement la première opération réalisée sur le dispositif 100, le passage d'un état passant ON à un état bloqué OFF et le passage d'un état bloqué OFF à un état passant ON.

On notera que par souci de simplification, les figures 5 à 7 ne représentent qu'une partie du dispositif 100, la zone isolante supérieure 101 ainsi que la zone inférieure 108B de la troisième électrode ayant été omises.

Selon une première configuration non représentée, des ions métalliques (ici des ions Cu²⁺) soit issus de l'une des électrodes 103 ou 104 soit déjà présents dans l'électrolyte 102 sont initialement dispersés dans tout l'électrolyte solide 102. Ainsi, aucun contact électrique n'est établi entre les première et deuxième électrodes 103 et 104 formant l'anode et la cathode de l'électrolyte. L'électrolyte solide 102 forme alors une zone électriquement isolante de grande résistivité entre la première et la deuxième électrode 103 et 104. Une première opération illustrée en figure 5, dite de formation de dendrites dans le dispositif 100, est réalisée en appliquant une différence de potentiel entre la première électrode 103 et la deuxième électrode 104, par exemple sous la forme d'une rampe de tension. Les ions métalliques Cu²⁺ initialement dispersés dans l'électrolyte solide 14 migrent alors vers la deuxième électrode 104 pour former un dépôt métallique. Ce dépôt métallique prend la forme de nanofils métalliques, appelés « dendrites », croissant progressivement au sein du milieu électrolytique sous l'effet de la tension appliquée et finissant par établir des ponts de conduction électrique entre la première et la deuxième électrode; une dendrite 113 est représentée en figure 5. L'électrolyte solide 104 forme alors une zone électriquement conductrice grâce à la dendrite métallique 113 formée entre la première et la deuxième électrode. On notera que l'application d'une tension négative sur la troisième électrode 108A permet en outre de créer la dendrite proche (et même au contact) de la barrière de diffusion 107. L'application de cette tension sur la troisième électrode 108A va en effet générer un champ électrique E dont la direction va avoir tendance à faire migrer les ions Cu²⁺ vers la barrière 107. Il convient également de noter que la dendrite 113 n'est pas de hauteur uniforme sur toute la longueur de l'électrolyte 102: on observe ainsi une première zone Z1 avec une épaisseur métallique plus importante qu'une seconde zone Z2. La configuration des potentiels appliqués sur les trois électrodes peut ainsi être la suivante : un potentiel V1 nul sur la première électrode 103, un potentiel V2 négatif sur la deuxième électrode 104 et un potentiel V3 négatif sur la troisième électrode 108A.

Une fois la dendrite 113 réalisée, le dispositif 100 peut passer du mode passant (résistant basse) ON au mode bloqué (résistance) OFF (et inversement du mode OFF au mode ON) en utilisant uniquement le potentiel de la troisième électrode 108A.

Comme nous allons le voir en référence aux figures 6 et 7, la troisième électrode 108A va ainsi permettre de jouer sur la longueur de la dendrite 113 initialement formée en cassant le pont conducteur formé par la dendrite entre la première et la deuxième électrode 103 et 104 pour passer de l'état ON à l'état OFF (par exemple pour écrire un « 0 » dans le dispositif 100 fonctionnant en tant que cellule mémoire) ou en reformant ce pont conducteur entre la première et la deuxième électrode 103 et 104 pour passer de l'état OFF à l'état ON (par exemple pour écrire un « 1 » dans le dispositif 100 fonctionnant en tant que cellule mémoire). Cette troisième électrode sert donc typiquement à écrire/effacer une information binaire dans le dispositif représentée par l'état résistif du dispositif. On notera que les phases d'écriture/effacement sont donc réalisées au moyen de la troisième électrode 108A, la lecture de l'information liée à l'état résistif étant réalisée à l'aide d'un courant traversant l'électrolyte à l'aide d'une différence de potentiel entre les première et deuxième électrodes 103 et 104.

En figure 6, on applique un potentiel positif V4 sur la troisième électrode, les potentiels appliqués sur les première et deuxième électrodes 103 et 104 étant nuls ou quasi-nuls. La présence du potentiel V4>0 sur la troisième électrode 108A va créer un champ électrique E dirigé vers le haut qui avoir tendance à faire migrer une partie des ions Cu²⁺ vers le haut et casser ainsi le pont conducteur formé par la dendrite 113 entre les première et deuxième électrodes 103 et 104. Ce phénomène est ici observé car la dendrite 113 telle qu'illustrée sur la figure 5 présente une dimension (i.e. une épaisseur) non uniforme sur toute la longueur de l'électrolyte 102 de sorte que l'effet du champ électrique E n'est pas le même sur toute la longueur de la dendrite 113; en d'autres termes, la dendrite va se casser préférentiellement au niveau de la zone Z2 d'épaisseur moins importante et se maintenir en l'état dans la zone Z1. L'état résistif représenté en figure 6 est donc un état OFF à haute résistance puisque le pont conducteur entre les électrodes 103 et 104 n'est plus assuré.

Inversement, en figure 7, on applique un potentiel positif V5 sur la troisième électrode, les potentiels appliqués sur les première et deuxième électrodes 103 et 104 étant nuls ou quasi-nuls. La présence du potentiel V5>0 sur la troisième électrode 108A va créer un champ électrique E dirigé vers le bas qui avoir tendance à faire migrer une partie des ions Cu²⁺ vers le bas et reformer ainsi le pont conducteur formé par la dendrite 113 entre les première et deuxième électrodes 103 et 104. L'état résistif représenté en figure 7 est donc un état ON à basse résistance puisque le pont conducteur entre les électrodes 103 et 104 est à nouveau assuré.

Grâce au dispositif selon l'invention, on peut ainsi passer d'un état résistif à l'autre en appliquant un potentiel ad hoc sur la troisième électrode 108A sans faire passer de courant dans l'électrolyte 102. Le potentiel appliqué sur la troisième électrode 108A peut ainsi être suffisamment élevé pour obtenir l'état résistif voulu sans avoir de courant de fuite parasite traversant l'électrolyte 102.

Bien entendu, pour que le dispositif 100 selon l'invention fonctionne, il est important que la barrière 107 soit non conductrice des ions et des électrons de manière à isoler la troisième électrode 108A de l'électrolyte 102 et à éviter notamment qu'un pont conducteur puisse se former entre l'électrolyte et la troisième électrode 108A. La hauteur de la barrière de diffusion 107 est de l'ordre d'une dizaine de nanomètres, par exemple 20 nm.

La première étape illustrée en figure 5 se produit lors de la première opération (formation du pont conducteur) ; ensuite, la destruction du pont ou sa reformation se font localement à l'aide du champ électrique généré par le potentiel appliqué sur la troisième électrode 108A.

On notera que la destruction et la formation du pont sont rendues possibles dans le cas du dispositif 100 des figures 4 à 7 par la non uniformité de la dendrite 113 de sorte que l'effet du champ électrique n'est pas le même sur toute la longueur de la dendrite.

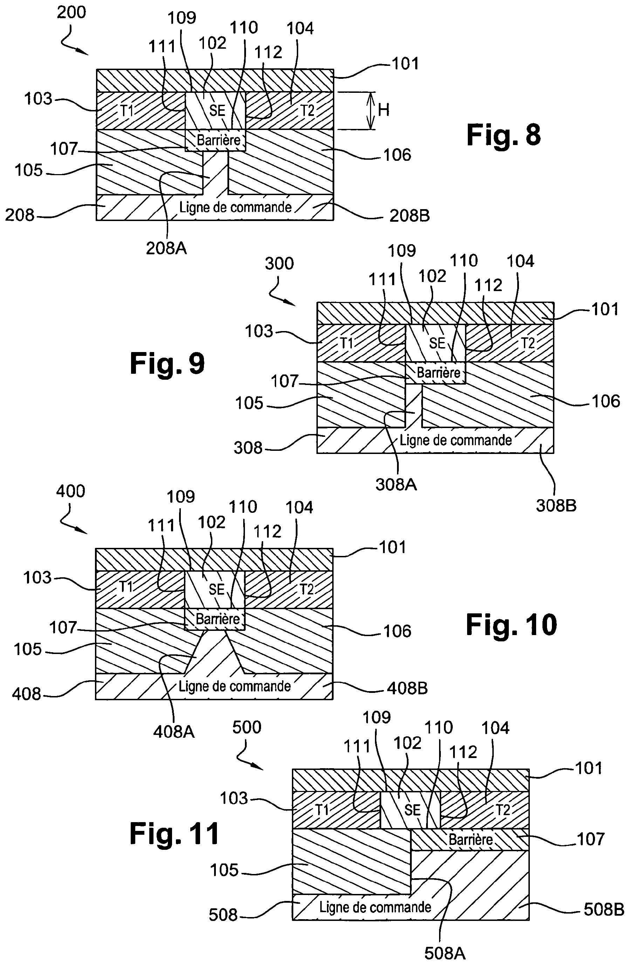

Selon un deuxième mode de réalisation particulièrement avantageux représenté en figure 8, il est possible d'avoir un dispositif selon l'invention fonctionnant également avec une dendrite dont les dimensions (et notamment son épaisseur) sont uniformes sur toute la longueur de l'électrolyte 102.

Le dispositif 200 de la figure 8 est identique au dispositif 100 des figures 4 à 7 (les caractéristiques communes portant les mêmes références), la seule différence consistant à utiliser une troisième électrode 208 formée par une zone inférieure 208B et une zone supérieure 208, ladite zone supérieure 208A ne s'étend pas sur toute la longueur de l'électrolyte 102.

En l'espèce, la zone supérieure 208A est ici localisée sensiblement au centre de la barrière de diffusion 107 de sorte que, lorsqu'un potentiel est appliqué sur la troisième électrode 208, le champ électrique généré par l'application d'un potentiel sur la troisième électrode 208 va être concentré dans une zone localisée au centre de l'électrolyte. Ainsi, quelle que soit l'uniformité de la dendrite, la rupture de cette dernière est parfaitement contrôlée car on applique un champ localisé qui permet de contrôler la zone de rupture du pont (i.e. la dendrite) conducteur entre les première et deuxième électrodes 103 et 104. Une telle configuration permet un meilleur contrôle (et une meilleure répétition) des opérations (ON vers OFF et OFF vers ON) quelles que soient les dimensions de la dendrite.

Les figures 9 à 11 illustrent des modes de réalisations qui constituent des déclinaisons du mode de réalisation décrit en référence à la figure 8. Dans tous les cas, le contact entre la troisième électrode et la barrière de diffusion 107 se fait uniquement sur une partie de la longueur totale de l'électrolyte 102.

Concernant la figure 9, la zone supérieure 308A de la troisième électrode 308 se situe à proximité de l'une des extrémités de la barrière 107 (en l'espèce l'extrémité proche de la première électrode 103) de sorte que, lorsqu'un potentiel est appliqué sur la troisième électrode 308, le champ électrique généré par l'application d'un potentiel sur la troisième électrode 308 va être concentré dans une zone localisée à une extrémité de l'électrolyte.

Concernant la figure 10, tout comme sur la figure 8, la zone supérieure 408A est ici localisée sensiblement au centre de la barrière de diffusion 107 de sorte que, lorsqu'un potentiel est appliqué sur la troisième électrode 408, le champ électrique généré par l'application d'un potentiel sur la troisième électrode 408 va être concentré dans une zone localisée au centre de l'électrolyte. La zone supérieure 408A a ici une forme trapézoïdale qui permet d'avoir une zone de localisation très précise et délimitée pour appliquer le potentiel. La forme trapézoïdale peut également être remplacée par une forme triangulaire.

Concernant la figure 11, la zone supérieure 508A de la troisième électrode 508 se situe sensiblement sur une moitié de la barrière 107 (en l'espèce la moitié proche de la seconde électrode 104) de sorte que, lorsqu'un potentiel est appliqué sur la troisième électrode 308, le champ électrique généré par l'application d'un potentiel sur la troisième électrode 308 va être concentré dans une zone localisée sur cette moitié de l'électrolyte.

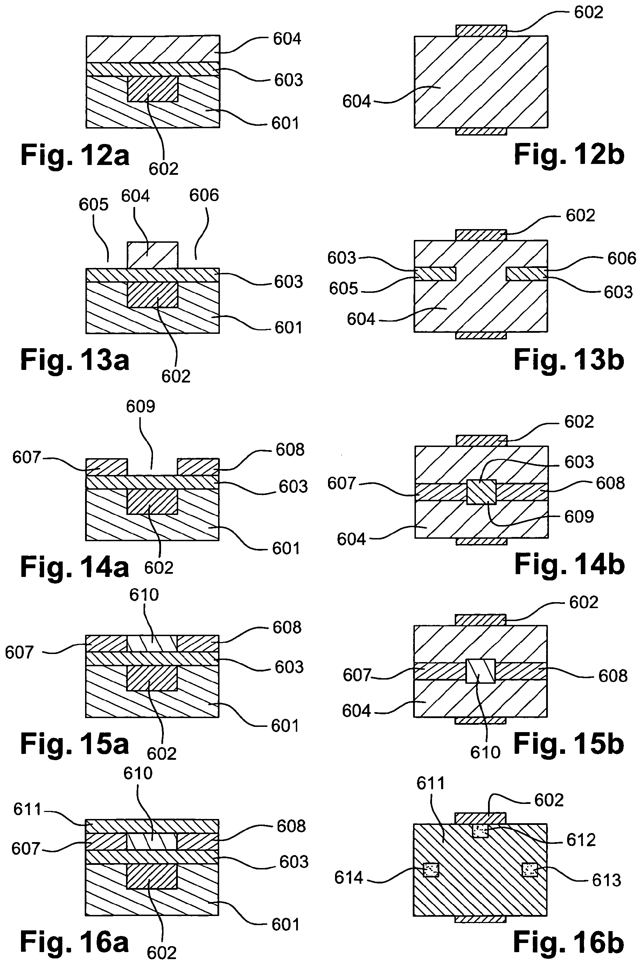

Nous allons maintenant décrire en référence aux figures 12a et 12b à 16a et 16b un exemple de mode de réalisation illustrant les étapes principales d'un procédé de fabrication d'un dispositif selon l'invention.

La première étape illustrée respectivement sur les figures 12a et 12b (respectivement en vue de côté et en vue de dessus) consiste à réaliser le contact métallique inférieur 601 correspondant à la troisième électrode du dispositif selon l'invention ; cette étape peut être réalisée par photolithogravure et métallisation d'une couche d'oxyde diélectrique 602 (par exemple en SiO₂) de manière à obtenir une ligne de métal qui formera la troisième électrode. Une étape de planarisation de la surface de la ligne de métal 601, par exemple par polissage mécano-chimique ou CMP (« Chemical-Mechanical Polishing » en anglais) peut ensuite être effectuée.

On réalise ensuite successivement le dépôt d'une couche diélectrique de barrière de diffusion 603 (par exemple en SiN, SiC, AIN ou SiCN.) imperméable aux ions et aux électrons puis d'une couche diélectrique isolante 604 (par exemple en SiO₂).

En référence aux figures 13a et 13b (respectivement en vue de côté et vue de dessus), on réalise ensuite une ou plusieurs étapes de photolithogravure au-travers de la couche diélectrique isolante 604 de manière à obtenir deux ouvertures 605 et 606. La forme des ouvertures 605 et 606 correspond à la forme respective des première et deuxième électrodes du dispositif selon l'invention.

En référence aux figures 14a et 14b (respectivement en vue de côté et vue de dessus), on réalise une étape de dépôt de métal tel que du Cu pour obtenir les première et deuxième électrodes 607 et 608 du dispositif selon l'invention au sein des deux ouvertures 605 et 606 précédemment illustrées. Le dépôt métallique peut être réalisé par une technique du type dépôt physique en phase vapeur PVD (« Physical Vapor Deposition » en anglais), par exemple par pulvérisation cathodique. Une étape de planarisation de la surface des électrodes métalliques, par exemple par polissage mécano-chimique CMP peut ensuite être effectuée. On retire par gravure une zone de la couche diélectrique isolante 604 située entre les deux électrodes de manière à former une ouverture 609 dont la forme correspond à la forme de l'électrolyte du dispositif selon l'invention.

En référence aux figures 15a et 15b (respectivement en vue de côté et vue de dessus), on réalise le dépôt de l'électrolyte solide 610 au sein de l'ouverture 609, à partir d'un matériau chalcogénure tel qu'un séléniure ou un tellurure, de certains oxydes tels que SiO₂, HfO₂, Ta₂O₅, TiO₂, GdOx, CuOx, WOx, ou de sulfures tels que GeSₓ, CuₓS ou AgS. Différentes techniques de dépôt peuvent être utilisées pour réaliser ce dépôt, par exemple des croissances de type CVD (« Chemical Vapor Deposition » en anglais) ou ALD (« Atomic Layer Deposition » en anglais).

Une étape de planarisation de la surface formée par les deux électrodes 607 et 608 et l'électrolyte solide 610, par exemple par polissage mécano-chimique ou CMP peut ensuite être effectuée.

En référence aux figures 16a et 16b (respectivement en vue de côté et vue de dessus), on réalise ensuite le dépôt d'une couche diélectrique isolante supérieure (par exemple en SiO₂) 611 qui vient recouvrir les première et deuxième électrodes 607 et 608 ainsi que l'électrolyte solide 610. Des contacts d'accès 612, 613 et 614 peuvent par ailleurs être obtenus par la réalisation de via métalliques d'accès respectif à la troisième électrode 602, à la deuxième électrode 608 et à la première électrode 607.

Le dispositif selon l'invention trouve une application particulièrement intéressante dans le domaine des réseaux logiques programmables FPGA (« Field-Programmable Gate Array » en anglais) et plus précisément en utilisant le dispositif dans une matrice de commutation (« switch block » en anglais) d'un tel réseau FPGA.

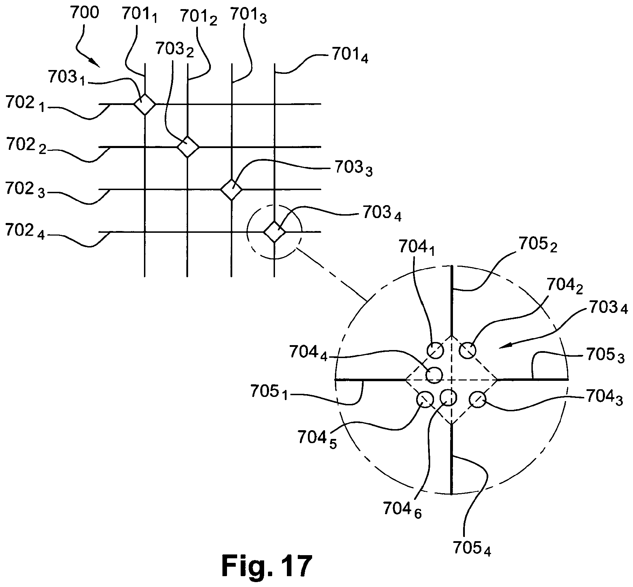

Les circuits FPGA sont constitués d'une matrice de blocs logiques programmables CLB (« Configurable Logic Bloc » en anglais) entourés de blocs d'entrée sortie programmable. Les blocs CLB sont reliés par un réseau d'interconnexions programmable sous la forme d'une matrice d'interconnexion telle que la matrice 700 illustrée en figure 17. Le rôle d'une matrice d'interconnexion est de relier les CLB entre eux. La matrice 700 est composée de segments conducteurs verticaux 701ᵢ (ici 4 segments verticaux 701₁ à 701₄, i variant de 1 à 4) et de segments conducteurs horizontaux 702ᵢ (ici 4 segments horizontaux 702₁ à 702₄, i variant de 1 à 4).

Chaque point d'intersection d'un segment horizontal et d'un segment vertical se trouvant sur la diagonale de la matrice 700 est un module d'interconnexion 703i (ici 4 modules d'interconnexion 703₁ à 703₄, i variant de 1 à 4).

A titre illustratif, un agrandissement du module d'interconnexion 703₄ est également représenté en figure 17, les autres modules d'interconnexion 703₁ à 703₃ étant identiques.

Selon l'invention, ce module d'interconnexion 703₄ comporte six dispositifs 704ᵢ selon l'invention (704₁ à 704₆). Chaque dispositif 704ᵢ est par exemple identique au dispositif 100 représenté en figure 1.

Quatre zones de segments 705₁ à 705₄ se rejoignent au niveau du module 703₄. Le principe de fonctionnement du module 703₄ est que chacune des quatre zones de segments 705₁ à 705₄ peut être reliée à l'une quelconque des trois zones de segments restantes via l'un des six dispositifs selon l'invention 704₁ à 704₆ agissant comme un commutateur commandé en tension.

La plupart des modules d'interconnexion des blocs logiques des grands FPGA modernes comportent des dispositifs du type SRAM (mémoires vives statiques ou « Static RAM » en anglais), EEPROM ou anti-fusible (« anti-fuse » en anglais) pour la réalisation des commutateurs. La technologie anti-fusible est une technologie moins chère que les technologies SRAM et EEPROM, elle permet d'atteindre des vitesses plus élevées et occupe moins de place sur le circuit. Par contre, elle ne peut être programmée qu'une seule fois. La technologie EEPROM nécessite des étapes de masquage supplémentaires lors de sa fabrication par rapport à la fabrication des technologies SRAM et anti-fuse. La technologie SRAM présente les performances les plus faibles et requiert une surface de silicium très importante, son principal avantage résidant dans son grand nombre de cycles d'écriture (versus les technologies anti-fusible et EEPROM) et dans le fait qu'elle permet une reconfiguration rapide au sein même du circuit (contrairement à la technologie anti-fusible).

Le dispositif selon l'invention permet d'allier l'ensemble des performances des technologies précitées : des performances en vitesse semblables à celle des technologies anti-fusible, une capacité à absorber un grand nombre de cycles d'écriture, une faible surface utilisée et un faible nombre d'étapes de fabrication.

Bien entendu, le dispositif et le procédé selon l'invention ne sont pas limités aux modes de réalisation qui viennent d'être décrits à titre indicatif et nullement limitatif en référence aux figures 1 à 17.

Ainsi, même si l'invention a été décrite de manière illustrative à l'aide d'une dendrite, il est entendu que le dispositif selon l'invention peut comporter une pluralité de dendrites réparties au sein de l'électrolyte. Sa faible consommation en puissance permet par ailleurs une reconfiguration rapide au sein même du circuit.

En outre, les ions métalliques présents dans l'électrolyte peuvent être obtenus soit via le métal de l'une des première ou deuxième électrodes de métal soluble (Ag ou Cu) qui se dissout dans l'électrolyte (dissolution soit spontanée soit stimulée) mais il est également possible d'obtenir un électrolyte comportant des ions métalliques obtenus par copulvérisation du matériau de l'électrolyte solide et d'un métal soluble dans le matériau de l'électrolyte solide de façon à obtenir une électrolyte intégrant des ions métalliques.

Enfin, même si l'invention a été décrite dans le cas de deux électrodes (la première et la deuxième électrodes) réalisées dans un métal soluble (Ag ou Cu par exemple), il est également possible de mettre en oeuvre l'invention avec une seule électrode en métal soluble, l'autre étant en métal non soluble (par exemple en TiN) voire même avec deux électrodes en métal non soluble dans le cas d'un électrolyte obtenu par copulvérisation.

## Revendications

1. Dispositif électronique (100, 200, 300, 400, 500) comportant :
- une première électrode (103) ;
- une deuxième électrode (104) ;
- un électrolyte solide (102) à base d'un matériau conducteur ionique, lesdites première et deuxième électrodes (103, 104) étant respectivement en contact avec l'une des faces (111, 112) dudit électrolyte (102) de part et d'autre dudit électrolyte, lesdites première et deuxième électrodes (103, 104) étant configurées pour former une dendrite métallique (113) entre ladite première électrode et ladite deuxième électrode (103, 104) à partir des ions métalliques circulant dans ledit électrolyte (102) lorsqu'une différence de potentiel est appliquée entre lesdites première et deuxième électrodes (103, 104) ;
ledit dispositif (100) étant **caractérisé en ce qu'**il comporte en outre :
- une troisième électrode (108, 108A, 108B, 208, 208A, 208B, 308, 308A, 308B, 408, 408A, 408B, 508, 508A, 508);
- une couche d'interface (107) en contact avec ladite troisième électrode (108A, 208A, 308A, 408A, 508A) et avec une troisième face (110) dudit électrolyte (102) différente des faces de contact (111, 112) desdites première et deuxième électrodes (103, 104), ladite couche d'interface (107) étant isolante ionique et isolante électronique, ladite couche d'interface (107) étant disposée entre ladite troisième face (110) et ladite troisième électrode (108A, 208A, 308A, 408A, 508A) de sorte qu'elle agit comme barrière électronique et ionique entre ledit électrolyte (102) et ladite troisième électrode (108, 108A, 108B, 208, 208A, 208B, 308, 308A, 308B, 408, 408A, 408B, 508, 508A, 508B) ;
ladite troisième électrode (108, 108A, 108B, 208, 208A, 208B, 308, 308A, 308B, 408, 408A, 408B, 508, 508A, 508B) et ladite dendrite (113) étant agencées de sorte que ledit dispositif (100) présente deux états résistifs :
- un premier état résistif haut lorsqu'un premier potentiel est appliqué à ladite troisième électrode (108, 108A, 108B, 208, 208A, 208B, 308, 308A, 308B, 408, 408A, 408B, 508, 508A, 508B) de sorte qu'une partie des ions formant ladite dendrite (113) migrent sous l'effet d'un premier champ électrique engendré par ledit premier potentiel et quittent ladite dendrite (113) qui n'assure plus le contact électrique entre ladite première et ladite deuxième électrode (103, 104) ;
- un deuxième état résistif bas lorsqu'un deuxième potentiel différent dudit premier potentiel est appliqué à ladite troisième électrode (108, 108A, 108B, 208, 208A, 208B, 308, 308A, 308B, 408, 408A, 408B, 508, 508A, 508B) de sorte que ladite partie des ions ayant quitté ladite dendrite (113) migrent sous l'effet d'un second champ électrique de direction opposée au dit premier champ électrique et engendré par ledit deuxième potentiel de façon à reformer ladite dendrite (113) entre ladite première électrode (103) et ladite deuxième électrode (104).
ledit contact entre ladite troisième électrode (208A, 308A, 408A, 508A) et ladite couche d'interface (107) se fait uniquement sur une partie de la longueur totale de l'électrolyte (102), ladite longueur totale étant la longueur de l'électrolyte prise entre la première et la deuxième électrode, de sorte que le champ électrique généré par l'application d'un potentiel sur ladite troisième électrode est concentré au niveau de ladite partie de la longueur totale de l'électrolyte.

2. Dispositif (100) selon la revendication précédente **caractérisé en ce que** ladite au moins une dendrite (113) présente au moins une dimension non uniforme le long de l'électrolyte (102).

3. Dispositif (200, 400) selon l'une des revendications précédentes **caractérisé en ce que** ledit contact entre ladite troisième électrode (208A, 408A) et ladite couche d'interface (107) se fait sur une zone sensiblement au milieu dudit électrolyte (102).

4. Dispositif (300) selon l'une des revendications 1 ou 2 **caractérisé en ce que** ledit contact entre ladite troisième électrode (308A) et ladite couche d'interface (107) se fait sur une zone sensiblement agencée à une extrémité dudit électrolyte (102).

5. Dispositif (500) selon l'une des revendications 1 ou 2 **caractérisé en ce que** ledit contact entre ladite troisième électrode (508A) et ladite couche d'interface (107) se fait sur une zone sensiblement agencée sur une moitié de la longueur dudit électrolyte (102).

6. Dispositif (100, 200, 300, 400, 500) selon l'une des revendications précédentes **caractérisé en ce que** ladite couche d'interface (107) est réalisée dans un matériau diélectrique tel que du SiN, SiC, AIN ou SiCN.

7. Dispositif (100, 200, 300, 400, 500) selon l'une des revendications précédentes **caractérisé en ce que** ledit électrolyte solide (102) est réalisé à partir d'un matériau chalcogénure tel qu'un séléniure ou un tellurure, de certains oxydes tels que SiO₂, HfO₂, Ta₂O₅, TiO₂, GdOx, CuOx, WOx, ou de sulfures tels que GeSₓ, CuₓS ou AgS.

8. Dispositif (100, 200, 300, 400, 500) selon l'une des revendications précédentes **caractérisé en ce qu'**il comporte deux zones isolantes électriquement (105, 106) aptes à isoler ladite troisième électrode respectivement desdites première et deuxième électrode.

9. Dispositif (100, 200, 300, 400, 500) selon l'une des revendications précédentes **caractérisé en ce que** ladite au moins une dendrite métallique est localisée à proximité de ladite couche d'interface.

10. Dispositif selon l'une des revendications précédentes **caractérisé en ce qu'**il comporte une pluralité de dendrites métalliques.

11. Cellule mémoire comportant un dispositif selon l'une des revendications précédentes **caractérisée en ce que** les deux états binaires de la mémoire sont respectivement représentés par l'état résistif haut et bas du dispositif.

12. Module d'interconnexion (703₄) des blocs logiques appartenant à un circuit logique programmable comportant au moins un dispositif selon l'une des revendications 1 à 10, ledit dispositif reliant deux zones de segments conducteurs.

## Patentansprüche

1. Elektronische Vorrichtung (100, 200, 300, 400, 500), umfassend:
- eine erste Elektrode (103);
- eine zweite Elektrode (104);
- ein festes Elektrolyt (102) aus einem leitenden ionischen Material, wobei die genannten ersten und zweiten Elektroden (103, 104) jeweils mit einer der Seiten (111, 112) des genannten Elektrolyts (102) auf jeder Seite des genannten Elektrolyts in Kontakt ist, wobei die genannten ersten und zweiten Elektroden (103, 104) konfiguriert sind, um einen metallischen Dendrit (113) zwischen der genannten ersten Elektrode und der genannten zweiten Elektrode (103, 104) ausgehend von den metallischen Ionen zu bilden, die in dem genannten Elektrolyt (102) zirkulieren, wenn eine Potenzialdifferenz zwischen den genannten ersten und zweiten Elektrolyten (103; 104) angewendet wird;
wobei die genannte Vorrichtung (100) **dadurch gekennzeichnet ist, dass** sie darüber hinaus umfasst:
- eine dritte Elektrode (108, 108A, 108B, 208, 208A, 208B, 308, 308A, 308B, 408, 408A, 408B, 508, 508A, 508B);
- eine Schnittstellenschicht (107), die mit der genannten dritten Elektrode (108A, 208A, 308A, 408A, 508A) und mit einer dritten Seite (100) des genannten Elektrolyts (102) in Kontakt ist, das unterschiedlich von den Kontaktseiten (111, 112) der genannten ersten und zweiten Elektroden (103, 104) ist, wobei die genannte Schnittstellenschicht (107) ionisch isolierend und elektronisch isolierend ist, wobei die genannte Schnittstellenschicht (107) zwischen der genannten dritten Seite (110) und der genannten dritten Elektrode (108A, 208A, 308A, 408A, 508A) derart angeordnet ist, dass sie als elektronische und ionische Schranke zwischen dem genannten Elektrolyt (102) und der genannten dritten Elektrode (108, 108A, 108B, 208, 208A, 208B, 308, 308A, 308B, 408, 408A, 408B, 508, 508A, 508B) wirkt;
wobei die genannte dritte Elektrode (108, 108A, 108B, 208, 208A, 208B, 308, 308A, 308B, 408, 408A, 408B, 508, 508A, 508B) und den genannten Dendrit (113) derart angeordnet sind, dass die genannte Vorrichtung (100) zwei ohmsche Zustände aufweist:
- einen ersten hohen ohmschen Zustand, wenn ein erstes Potenzial auf die genannte dritte Elektrode (108, 108A, 108B, 208, 208A, 208B, 308, 308A, 308B, 408, 408A, 408B, 508, 508A, 508B) derart angewendet wird, dass ein Teil der den genannten Dendrit (113) bildenden Ionen unter der Wirkung eines ersten elektrischen Feldes migriert, das durch das genannte erste Potenzial erzeugt wird, und den genannten Dendrit (113) verlässt, der den elektrischen Kontakt zwischen der genannten ersten und der genannten zweiten Elektrode (103; 104) nicht mehr gewährleistet;
- einen zweiten tiefen ohmschen Zustand, wenn ein zweites Potenzial, das von dem ersten Potenzial unterschiedlich ist, auf die genannte dritte Elektrode (108, 108A, 108B, 208, 208A, 208B, 308, 308A, 308B, 408, 408A, 408B, 508, 508A, 508B) derart angewendet wird, dass der genannte Teil der Ionen, der den genannten Dendrit (113) verlassen hat, unter der Wirkung eines zweiten elektrischen Feldes mit der von der des ersten elektrischen Feldes entgegengesetzter Richtung und das durch das genannte zweite Potenzial erzeugt wird, derart migriert, dass der genannte Dendrit (113) zwischen der genannten ersten Elektrode (103) und der genannten zweiten Elektrode (104) neu geformt wird,
wobei der genannte Kontakt zwischen der genannten dritten Elektrode (208A, 308A, 408A, 508A) und der genannten Schnittstellenschicht (107) nur auf einem Teil der Gesamtlänge des Elektrolyts (102) erfolgt, wobei die genannte Gesamtlänge die Länge des Elektrolyts ist, die zwischen der ersten und der zweiten Elektrode berücksichtigt ist, derart, dass das elektrische Feld, das durch die Anwendung eines Potenzials auf der genannten dritten Elektrode erzeugt wird, auf dem dritten Teil der Gesamtlänge des Elektrolyts konzentriert ist.

2. Vorrichtung (100) gemäß dem voranstehenden Anspruch, **dadurch gekennzeichnet, dass** der genannte wenigstens eine Dendrit (113) wenigstens eine nicht einheitliche Abmessung entlang des Elektrolyts (102) aufweist.

3. Vorrichtung (200, 400) gemäß einem der voranstehenden Ansprüche, **dadurch gekennzeichnet, dass** der genannte Kontakt zwischen der genannten dritten Elektrode (208A, 408A) und der genannten Schnittstellenschicht (107) auf einer Zone erfolgt, die sich deutlich in der Mitte des genannten Elektrolyts (102) befindet.

4. Vorrichtung (300) gemäß Anspruch 1 oder 2, **dadurch gekennzeichnet, dass** der genannte Kontakt zwischen der genannten dritten Elektrode (308A) und der genannten Schnittstellenschicht (107) auf einer Zone erfolgt, die deutlich an einem Ende des genannten Elektrolyts (10) angeordnet ist.

5. Vorrichtung (500) gemäß Anspruch 1 oder 2, **dadurch gekennzeichnet, dass** der genannte Kontakt zwischen der genannten dritten Elektrode (508A) und der genannten Schnittstellenschicht (107) auf einer Zone erfolgt, die deutlich auf einer Hälfte der Länge des genannten Elektrolyts (102) angeordnet ist.

6. Vorrichtung (100, 200, 300, 400, 500) gemäß einem der voranstehenden Ansprüche, **dadurch gekennzeichnet, dass** die genannte Schnittstellenschicht (107) aus einem dielektrischen Material realisiert ist, wie z. B. SiN, SiC, AIN oder SiCN.

7. Vorrichtung (100, 200, 300, 400, 500) gemäß einem der voranstehenden Ansprüche, **dadurch gekennzeichnet, dass** das genannte feste Elektrolyt (102) aus einem Chalkogenid-Material, wie z. B. einem Selenid oder einem Tellurid, aus bestimmten Oxiden, wie z. B. SiO₂, HfO_{2,} Ta₂O₅, TiO₂, GdOx, CuOx, WOx oder aus Sulfiden, wie z. B. GeSₓ, CuₓS oder AgS realisiert ist.

8. Vorrichtung (100, 200, 300, 400, 500) gemäß einem der voranstehenden Ansprüche, **dadurch gekennzeichnet, dass** sie zwei elektrisch isolierende Zonen (105, 106) umfasst, die geeignet sind, die genannte Elektrode jeweils von der ersten und zweiten Elektrode zu isolieren.

9. Vorrichtung (100, 200, 300, 400, 500) gemäß einem der voranstehenden Ansprüche, **dadurch gekennzeichnet, dass** der genannte wenigstens eine metallische Dendrit in der Nähe der genannten Schnittstellenschicht lokalisiert ist.

10. Vorrichtung gemäß einem der voranstehenden Ansprüche, **dadurch gekennzeichnet, dass** sie eine Vielzahl von metallischen Dendriten umfasst.

11. Speicherzelle, umfassend eine Vorrichtung gemäß einem der voranstehenden Ansprüche, **dadurch gekennzeichnet, dass** die zwei binären Zustände des Speichers jeweils durch den hohen und niedrigen ohmschen Zustand der Vorrichtung gekennzeichnet sind.

12. Verbindungsmodul (703₄) der logischen Blöcke, die zu einem programmierbaren logischen Schaltkreis gehören, welche wenigstens eine Vorrichtung gemäß Anspruch 1 bis 10 umfasst, wobei die genannte Vorrichtung zwei leitende Segmentzonen miteinander verbindet.

## Claims

1. An electronic device (100, 200, 300, 400, 500) comprising:
- a first electrode (103);
- a second electrode (104);
- a solid electrolyte (102) based on an ion-conducting material,
said first and second electrodes (103, 104) being respectively in contact with one of the faces (111, 112) of said electrolyte (102) on either side of said electrolyte, said first and second electrodes (103, 104) being configured to form a metal dendrite (113) between said first electrode and said second electrode (103, 104) from metal ions circulating in said electrolyte (102) when a potential difference is applied between said first and second electrodes (103, 104):
said device (100) being **characterized in that** it further comprises:
- a third electrode (108, 108A, 108B, 208, 208A, 208B, 308, 308A, 308B, 408, 408A, 408B, 508, 508A, 508B);
- an interface layer (107) in contact with said third electrode (108A, 208A, 308A, 408A, 508A) and with a third face (110) of said electrolyte (102) different from the contact faces (111, 112) of said first and second electrodes (103, 104), said layer interface (107) being an ionic and electronic insulator, said interface layer (107) being arranged between said third face (110) and said third electrode (108A, 208A, 308A, 408A, 508A) so that it acts as electronic and ionic barrier between said electrolyte (102) and said third electrode (108, 108A, 108B, 208, 208A, 208B, 308, 308A, 308B, 408, 408A, 408B, 508, 508A, 508B);
said third electrode (108, 108A, 108B, 208, 208A, 208B, 308, 308A, 308B, 408, 408A, 408B, 508, 508A, 508B) and said dendrite (113) being arranged such that said device (100) has two resistive states:
- a first high resistive state when a first potential is applied to said third electrode (108, 108A, 108B, 208, 208A, 208B, 308, 308A, 308B, 408, 408A, 408B, 508, 508A , 508B) so that a part of the ions forming said dendrite (113) migrate under the influence of a first electric field generated by said first potential and leave said dendrite (113) which no longer ensures the electrical contact between said first and said second electrode (103, 104);
- a second low resistive state when a second potential different from said first potential is applied to said third electrode (108, 108A, 108B, 208, 208A, 208B, 308, 308A, 308B, 408, 408A, 408B, 508, 808A, 508B) so that said part of the ions having left said dendrite (113) migrate under the effect of a second electric field having a direction opposite to said first electric field and generated by said second potential so as to reform said dendrite (113) between said first electrode (103) and said second electrode (104),
said contact between said third electrode (208A, 308A, 408A, 508A) and said interface layer (107) occurs only on a section of the total length of the electrolyte (102), said total length being the length of the electrolyte between the first and the second electrode, so that the electric field generated by applying a potential on said third electrode is concentrated at said section of the total length of the electrolyte.

2. The device (100) according to claim 1, **characterized in that** said at least one dendrite (113) has at least one non-uniform dimension along the electrolyte (102).

3. The device (200, 400) according to anyone of the preceding claims, **characterized in that** said contact between said third electrode (208A, 408A) and said interface layer (107) occurs in a substantially median area of said electrolyte (102).

4. The device (300) according to claim 1 or 2, **characterized in that** said contact between said third electrode (508A) and said interface layer (107) occurs in a area substantially arranged at one end of said electrolyte (102).

5. The device (500) according to claim 1 or 2, **characterized in that** said contact between said third electrode (508A) and said interface layer (107) occurs in an area substantially arranged on a half of the length of said electrolyte (102).

6. The device (100, 200, 300, 400, 500) according to anyone of the preceding claims, **characterized in that** said interface layer (107) is made of a dielectric material such as SiN, SiC, AIN or SiCN.

7. The device (100, 200, 300, 400, 500) according to anyone of the preceding claims, **characterized in that** said solid electrolyte (102) is formed from a chalcogenide material, such as a selenide or a telluride, of some oxides such as SiO₂, HfO₂, Ta₂O₅, TiO₂, GdOx, CuOx, WOx or sulfides such as GeSₓ, CuₓS or AgS.

8. The device (100, 200, 300, 400, 500) according to anyone of the preceding claims, **characterized in that** it comprises two electrically insulating areas (105, 106) able to insulate said third electrode respectively from said first and second electrode.

9. The device (100, 200, 300, 400, 500) according to anyone of the preceding claims, **characterized in that** said at least one metallic dendrite is located near to said interface layer.

10. The device according to anyone of the preceding claims, **characterized in that** it comprises a plurality of metal dendrites.

11. A memory cell comprising a device according to anyone of the preceding claims, **characterized in that** the two binary states of the memory are respectively represented by the high and low resistive state of the device.

12. An interconnection module (703₄) of the logic blocks belonging to a programmable logic circuit comprising at least one device according to anyone of claims 1 to 10, said means connecting two area of conducting segments.
